# EUROPÄISCHE PATENTANMELDUNG

(11) **EP 2 663 070 A1**
(43) Veröffentlichungstag der Anmeldung: **13.11.2013**
(21) Anmeldenummer: 12003735.3
(22) Anmeldetag: 10.05.2012
(51) Int. Cl.: H04N 5/225, H01L 23/495

(54) **Bildsensor-Baugruppe für eine Kamera, sowie Verfahren und Biegewerkzeug zu dessen Herstellung**

(71) Anmelder: Basler AG, 22926 Ahrensburg (DE)
(72) Erfinder: Radeloff, Jens, 22941 Bargteheide (DE)
(74) Vertreter: Eisenführ, Speiser & Partner

(57) **Zusammenfassung**

Die Erfindung betrifft eine Bildsensor-Baugruppe für eine Kamera, vorzugsweise eine digitale Industriekamera, mit einer Leiterplatte (5) und einem oder mehreren elektronischen Bauteilen, ein Verfahren zu deren Herstellung und ein Biegewerkzeug, wobei zumindest eines der Bauteile ein modifizierter THD-Bildsensor (54) ist, der mittels eines angepassten Biegewerkzeugs modifizierte Bildsensor-Drahtanschlüsse aufweist, die durch ein Fertigungsverfahren auf der Oberfläche der Leiterplatte (5) montiert werden, so dass die Drahtanschlüsse nicht durch die Leiterplatte (5) durchgesteckt und verlötet werden müssen und dass sie eine Referenz zu einer optisch sensitiven Fläche des Bildsensors (54) bilden. Der modifizierte THD-Bildsensor (54) kann somit in einem SMD-Fertigungsprozess bestückt werden.

## Beschreibung

### Erfindungsgebiet:

Die Erfindung betrifft eine Bildsensor-Baugruppe für eine Kamera, insbesondere eine digitale Industriekamera, und ein Verfahren und ein Biegewerkzeug zu deren Herstellung.

### Hintergrund der Erfindung:

Im industriellen Umfeld werden vielfach digitale Kameras eingesetzt, um z.B. Produktionsprozesse, Maschinen oder Objekte zu überwachen. Solche Industriekameras werden für einfache Überwachungsaufgaben und für messtechnische Aufgabenstellungen wie bspw. Qualitätskontrolle mittels Bildverarbeitung eingesetzt. Sie zeichnen sich durch ihre Robustheit und hohe Bildqualität aus.

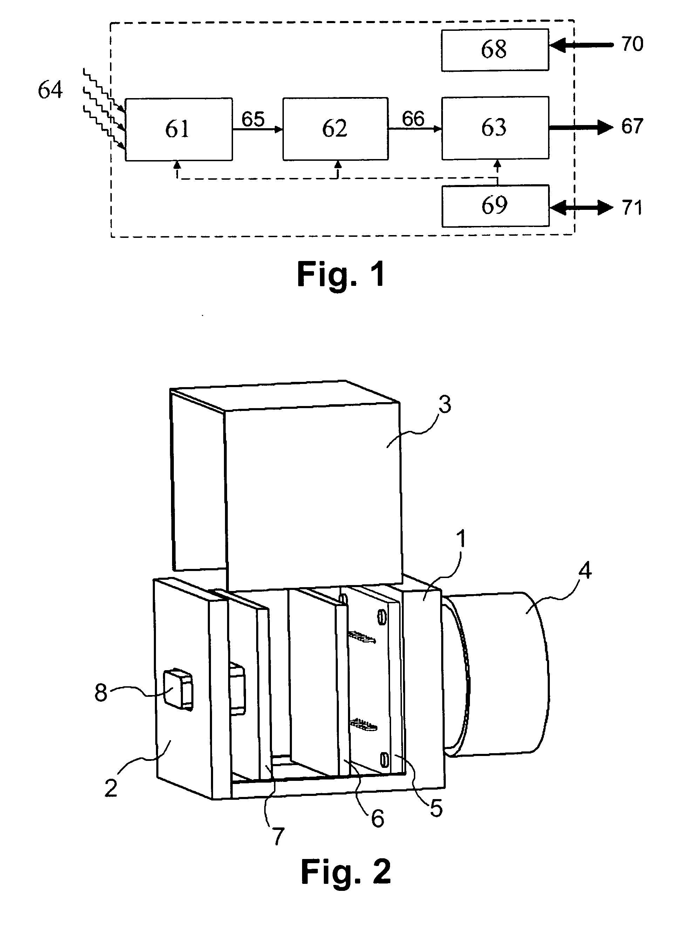

Fig. 1 zeigt eine schematische Darstellung von Funktionseinheiten einer digitalen Industriekamera die digitale Industriekamera umfasst typischerweise eine Bilddaten-Erfassungseinheit 61, eine Bilddaten-Verarbeitungseinheit 62 und eine Bilddaten-Ausgabeeinheit 63. Zur Bilddaten-Erfassung 61 wird ein Bildsensor verwendet, welcher einfallendes Licht 64 in elektronische Signale 65 konvertiert. Diese elektronischen Signale 65 werden danach in einer Bilddaten-Bearbeitungseinheit 62 bearbeitet. Typische Bearbeitungsaufgaben sind Digitalisierung oder Nachbearbeitung der Bilddaten zum Zwecke der Verbesserung der Bildqualität, z.B. Demosaicing. Nach erfolgter Bilddaten-Bearbeitung in der Bilddaten-Bearbeitungseinheit 62 werden die bearbeiteten Bilddaten 66 dann mittels der Bilddaten-Ausgabeeinheit 63 über eine Schnittstelle (nicht gezeigt in Fig.1) als digitales Signal 67 versendet, wobei die Versendung drahtgebunden oder drahtlos erfolgen kann. Die digitalen Signale 67 können dabei mindestens zwei diskrete Signalzustände, z.B. 0V und 5V, aufweisen. Neben der Bilddaten-Erfassungseinheit 61, der Bilddaten-Verarbeitungseinheit 62 und der Bilddaten-Ausgabeeinheit 63 kann die digitale Industriekamera noch weitere Komponenten aufweisen. Hierzu zählen ein oder mehrere Versorgungsanschlüsse 68 zur Versorgung der Kamera mit elektrischer Energie 70 und eine oder mehr Schnittstellen zur Eingabe von digitalen Steuersignalen 71 zur Beeinflussung von Kamera-Betriebszuständen der Kamerasteuerung 69.

Fig. 2 zeigt einen beispielhaften Aufbau einer Industriekamera, die aus mechanischen, optischen und elektronischen Komponenten besteht. Zu den mechanischen Komponenten gehört u.a. das Kamera-Gehäuse, welches z.B. aus einem Gehäuse-Träger 1, einer Gehäuse-Rückwand 2 und einem Gehäuse-Deckel 3 gebildet sein kann. Mechanische Komponenten haben mehrere Aufgaben. Sie geben u.a. der Kamera eine äußere Gestalt und dienen gleichzeitig der Befestigung weiterer Bestandteile, wie z.B. den optischen und elektronischen Komponenten. Zu den optischen Komponenten zählt das Objektiv 4, zu den elektronischen Komponenten zählen eine oder mehrere elektronische Baugruppen mit zugehörigen Leiterplatten 5, 6, 7. Die Befestigung des Objektivs 4 am Gehäuse-Träger 1 erfolgt mechanisch, bspw. mittels eines Gewindes. Bilddaten können über eine digitale Datenschnittstelle 8 ausgegeben werde.

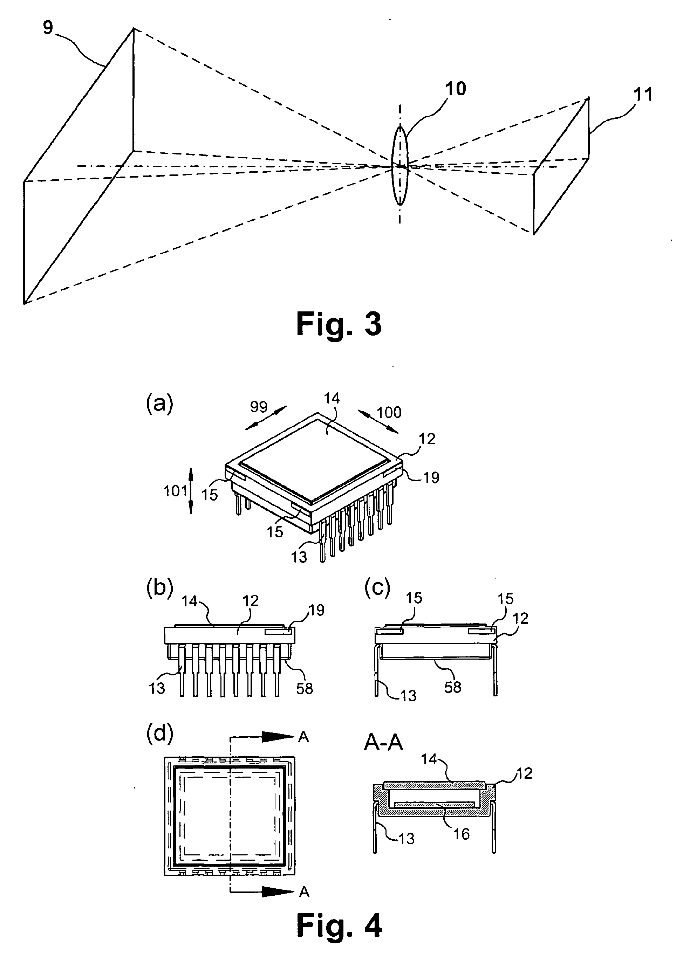

Fig. 3 zeigt anhand einer schematischen Skizze den Zusammenhang zwischen Objektebene 9 und Bildebene 11. Bei einem Objektiv handelt es sich um ein Linsensystem 10, welches einfallendes Licht sammelt und eine Projektion von einer Objektebene 9 auf die Bildebene 11 erzeugt.

Bei einer elektronischen Baugruppe handelt es sich um eine Komponente, die aus einer Leiterplatte und elektronischen Bauteilen besteht. Im Kontext einer digitalen Industriekamera werden elektronische Baugruppen z.B. genutzt, um die Funktion der Konvertierung des einfallenden Lichtes in elektronische Signale zu übernehmen. Die Leiterplatte dient dabei als mechanischer Träger und zur elektrischen Kontaktierung und Verbindung der elektronischen Bauteile. Leiterplatten weisen eine Oberseite und eine Unterseite auf. Die Oberseite wird meist als Top-Seite, die Unterseite meist als Bottom-Seite bezeichnet. Die Festlegung, welche Seite oben und welche unten ist, kann rein willkürlich erfolgen. Sowohl auf der Top- als auch auf der Bottom-Seite können elektronische Bauteile montiert werden. Als Montage-Platzhalter für elektronische Bauteile werden Strukturen auf der Leiterplatte vorgesehen, die der Fachmann als sogenannte Footprints bezeichnet. Die elektronischen Bauteile werden auf der Leiterplatte mittels Leiterbahnen elektrisch miteinander in der gewünschten Funktionalität verschaltet.

Bei den elektronischen Bauteilen handelt es sich um Funktionselemente, welche in einer elektronischen Baugruppe Teilaufgaben übernehmen (z.B. Widerstände, Induktivitäten, Kapazitäten, Integrierte Schaltkreise). Durch die Kombination vieler elektronischer Bauteile wird dann in Verbindung mit der Leiterplatte die gewünschte Funktionalität erreicht. Neben der Unterscheidbarkeit hinsichtlich ihrer Funktion lassen sich elektronische Bauteile aber auch durch die Art des Montageverfahrens auf der Leiterplatte differenzieren. Generell wird zwischen Oberflächen-montierten Bauteilen (Abkürzung: "SMD" für Surface Mounted Device) und bedrahteten Bauteilen (Abkürzung: "THD" für Through Hole Device) unterschieden. Bei THD-Bauteilen handelt es sich um Gehäuseformen mit mehreren Drahtanschlüssen. Ein Footprint für ein THD-Bauteil besteht aus einer Durchkontaktierung pro Drahtanschluss. Bei einer Durchkontaktierung handelt es sich bspw. um eine in die Leiterplatte eingebrachte Hülse mit einem Loch in der Mitte. THD-Bauteile werden standardmäßig in einem vorbereitenden Arbeitsschritt in die Durchkontaktierungen der Leiterplatte gesteckt und dort bis zur eigentlichen Montage fixiert.

Im Gegensatz dazu weisen SMD-Bauteile anstelle der Draht-Anschlüsse Anschlussflächen auf. Ein Footprint für ein SMD-Bauteil besteht bspw. aus Kupferpads, die sich auf der Top- oder Bottom-Seite der Leiterplatte befinden. Eine Teilkomponente der elektronischen Baugruppe ist die Leiterplatte. Auf der Leiterplatte werden elektronische Bauteile einseitig (Top- oder Bottom-Seite) oder beidseitig (Top- und Bottom-Seite) montiert. Weist eine elektronische Baugruppe nur SMD-Bauteile auf, handelt es sich um eine SMD-Baugruppe. Weist eine elektronische Baugruppe nur THD-Bauteile auf, spricht man von einer THD-Baugruppe. Besteht eine elektronische Baugruppe aus mindestens einem SMD-Bauteil und aus mindestens einem THD-Bauteil, so spricht man von einer mischbestückten Baugruppe.

Als Verfahren zur Montage elektrischer Bauteile auf der Leiterplatte kommt vorrangig das Löten zum Einsatz. Beim Löten handelt es sich um ein thermisches Verfahren, bei welchem die elektronischen Bauteile stoffschlüssig mit den Kontaktflächen der Leiterplatte verbunden werden. Hierbei kommen sogenannte Lote zum Einsatz. Lote können in verschiedenen Formen verarbeitet werden. Typische Lotformen sind der Lot-Draht, die Lot-Barren und die Lot-Paste. Beim Lot-Draht handelt es sich um einen massiven Draht der entsprechenden Lot-Legierung mit einem Durchmesser von typischerweise 0.3 bis 4mm. Der Lotdraht weist meist einen Kern aus Flussmittel auf. Flussmittel wird im Lötprozess verwendet, um die Lötstelle vor dem eigentlichen Löt-Prozess vorzubereiten. Hierbei werden eventuell vorhandene Oxidschichten entfernt und darüber hinaus die Ausbreitungseigenschaften des Lotes auf den Kontaktflächen verbessert. Bei Lot-Barren liegt das Lot in massiver Form als Barren in der gewünschten Legierung vor. Da der Lot-Barren kein eigenes Flussmittel mitbringt, muss vor dem eigentlichen Lötprozess Flussmittel manuell oder automatisch aufgetragen werden. Schließlich handelt es sich bei Lot-Pasten um ein Pasten-artiges Gemisch aus Flussmittel und Lotkugeln der entsprechenden Legierung. Typische Lot-Kugelgrößen Durchmesser liegen zwischen 20 bis 45µm. Der Prozess des Lötens kann unterschiedlich gestaltet sein. Weit verbreitete Löt-Techniken sind das Handlöten, das Wellenlöten und das Reflow-Löten. Beim Handlöten handelt es sich um einen manuellen Prozess, bei welchem Lot-Draht verwendet wird. Für den Lötprozess wird ein Lötkolben benötigt. Dieser ist ein Hilfsmittel, welches an der Lötkolbenspitze Wärme zur Verfügung stellt. Die Wärme wird zum Aufschmelzen des Lotdrahtes genutzt und muss somit mehr als die Schmelztemperatur des Lotes betragen. Handlöten läuft in folgenden Prozessschritten ab:
1.) Manuell Bauteil auf der Leiterplatte platzieren und in Position fixieren.
2.) Manuell Lötkolben gleichzeitig an die Kontaktfläche der Leiterplatte und an den Bauteil-Anschluss halten (Erwärmung der Lötstelle).
3.) Manuell Lot-Draht zuführen bis zum Aufschmelzen des Lotes.
4.) Manuell Lötkolben von Lötstelle entfernen (führt zum Erstarren der Verbindung).

Beim Wellenlöten handelt es sich um einen automatisierten Prozess. Hierbei wird das Lot in Barrenform in einen Lot-Tiegel gelegt, aufgeschmolzen und im flüssigen Zustand gehalten. Das Wellenlöten läuft in folgenden Prozessschritten ab:
1.) Manuell Bauteil auf der Leiterplatte platzieren und in Position fixieren.
2.) Leiterplatte der Wellenlötmaschine zuführen.
3.) Automatisches Besprühen der Lötstellen mit Flussmittel.
4.) Automatisches Löten durch Kontakt mit dem Lot des Lot-Tiegels.

Für das Reflow-Löten wird Lot-Paste verwendet. Der Prozess läuft in folgenden Prozessschritten ab:
1.) Automatisches Bedrucken der Leiterplatte mittels Schablonendruck und Lotpaste.
2.) Automatisches/Manuelles Platzieren der Bauteile auf der Leiterplatte.
3.) Automatisches Löten der Leiterplatte durch Lötmaschine.

Eines der wichtigsten Bauteile einer digitalen Industriekamera ist der Bildsensor. Bildsensoren gibt es in SMD- und in THD-Gehäuseformen.

Fig. 4 zeigt einen typischen Bildsensor mit einer THD-Gehäuseform in perspektivischer Ansicht (a), Ansicht von links (b), Ansicht von vorne (c), Ansicht von oben (d) und einer Schnitt-Ansicht (A-A) durch den Sensor entlang der in Fig. 4(d) gezeigten Schnittlinie. Der THD-Bildsensor besteht aus einem Bildsensor-Gehäuse 12 und einer Vielzahl von Drahtanschlüssen 13. Die Drahtanschlüsse 13 sind meist als lötbare Anschlussfähnchen mit rechteckigem Querschnitt ausgeführt. Wichtigster Bestandteil des THD-Bildsensors ist der auf Halbleitermaterial integrierte elektronische Schaltkreis, der sogenannte Chip oder Die 16. Der Die 16 beinhaltet u.a. die optisch aktive Fläche, welche einfallendes Licht sammelt und eine Konvertierung des Lichtes in elektronische Signale durchführt. Über die Drahtanschlüsse 13 wird der Bildsensor mit der für den Betrieb notwendigen Energie versorgt. Weiterhin erfolgt über die Drahtanschlüsse 13 die Eingabe bzw. Ausgabe von elektronischen Signalen. Als Schutz vor äußeren Einflüssen, wie z.B. Staub, wird der Bildsensor meist mit einem Deckglas 14 versehen.. Ferner sind Bildsensor-Referenzpositionen vorgesehen. Bildsensor-Referenzpositionen, aber auch bspw. Positionen-Angaben und -Abweichungen lassen sich gemäß dem kartesischen Koordinatensystem durch drei Raumrichtungen in X-Richtung 99, Y-Richtung 100 und Z-Richtung 101 beschreiben. Dementsprechend lassen sich die Bildsensor-Referenzpositionen 15, 19, und 58 der X-, Y- bzw. Z-Richtung zuordnen.

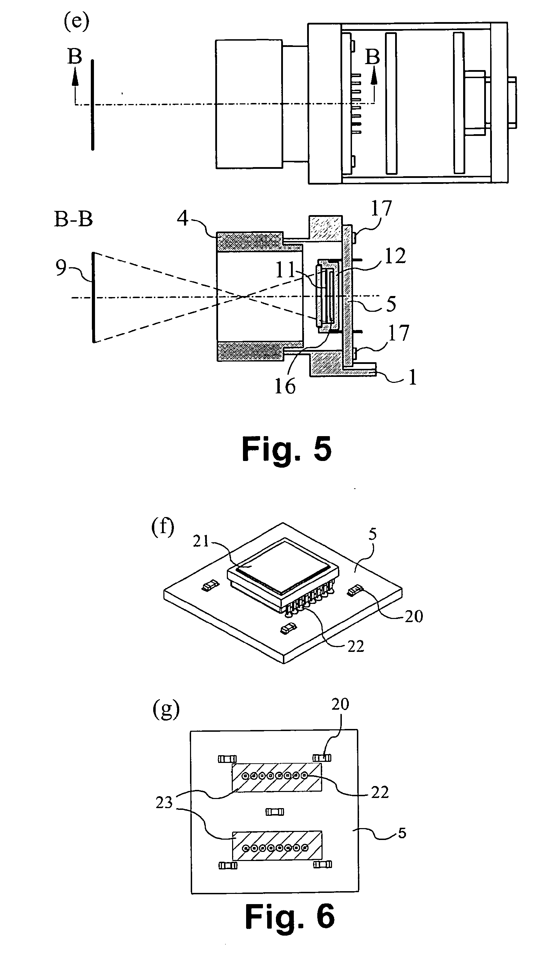

Fig. 5 zeigt eine Ansicht (e) der geöffnete Kamera mit Blick von oben und eine Schnitt-Ansicht (B-B) entlang der in Ansicht (e) gezeigten Schnittlinie mit dem optischen Strahlengang der Kamera bei einer Projektion der Objektebene 9 auf die optisch sensitive Fläche des Dies 16 des Bildsensors. Die optische Projektion der Objektebene 9 auf eine Bildebene 11 erfolgt mittels eines Objektivs 4. Gemäß Fig. 5 wird das Objektiv 4 am Kamera Gehäuse-Träger 1 montiert. Die Leiterplatte 5 der Bildsensor-Baugruppe ist bspw. mittels Schrauben 17 am Gehäuse-Träger 1 befestigt.

Durch eine fehlerhafte Ausrichtung der optisch sensitiven Fläche des Dies 16 zur Bildebene 11 kann es zu einem fehlerhaft erfassten Abbild der Objektebene kommen. Je nachdem welches Ausrichtungsproblem vorliegt, unterscheidet man zwischen folgenden Arten der Fehlausrichtung:
- Neigung oder Tilt: Hierbei sind die optisch sensitive Fläche des Dies 16 und die Bildebene 9 zueinander gekippt. Diese Fehlausrichtung wird als Bildsensor-Tilt bezeichnet und lässt sich durch einen Winkel beschreiben. Ein bei fehlerfreier Ausrichtung scharfes Abbild wird durch einen Bildsensor-Tilt zu einem Abbild mit scharfen und nachteilig unscharfen Bereichen.
- Z-Versatz: Hierbei sind die beiden Ebenen der optisch sensitiven Fläche des Dies 16 und der Bildebene 9 nicht deckungsgleich und somit verschoben in eine Richtung senkrecht zur optisch sensitiven Fläche des Dies 16. Ein derartiger Versatz führt zu einer nachteiligen Unschärfe im gesamten Abbild.
- X- bzw. Y-Versatz: Hierbei sind zwar die Flächen der optisch sensitiven Fläche des Dies 16 und der Bildebene 9 deckungsgleich, jedoch stimmen die Zentren der optisch sensitiven Fläche des Dies 16 und der Bildebene 9 nicht überein, sondern sind X-Richtung und Y-Richtung verschoben. Ein derartiger Versatz kann zu einer fehlerhaften Blickrichtung der Kamera führen (Schwenken der optischen Achse). Darüber hinaus kommt es möglicherweise zu nachteiligen Abschattungseffekten an den Rändern des Abbildes, wodurch das Abbild an diesen Stellen dunkler als im fehlerfreien Fall dargestellt wird.

Die Montage eines THD-Bildsensors kann auf unterschiedliche Arten erfolgen. In den meisten Fällen wird der Bildsensor auf einer Leiterplatte 5 verlötet und ist somit Bestandteil einer elektronischen Baugruppe, die als Bildsensor-Baugruppe bezeichnet wird. Um die Anforderung einer fehlerfreien Ausrichtung von optisch sensitiver Fläche des Dies 16 des Bildsensors zur Bildebene 11 zu erfüllen, wird das Bildsensor-Gehäuse 12 zur Leiterplatte 5 ausgerichtet. Beispielsweise erfolgt die Montage der Bildsensor-Baugruppe, bestehend aus der Leiterplatte 5 und dem THD-Bildsensor, am Gehäuse-Träger 1 der Kamera. Dabei wird die Baugruppe Gehäuseträger 1 ausgerichtet. Die Ausrichtung kann auch mittels konstruktiver Maßnahmen erfolgen. Da auch das Objektiv 4 zum Gehäuse-Träger 1 ausgerichtet ist, liegt dann eine Ausrichtung von Bildebene 11 zur optisch sensitiven Fläche des Dies 16 vor.

Die Ausrichtung eines THD-Bildsensors auf der Leiterplatte 5 erfolgt meist unter Verwendung eines Hilfswerkszeugs. Im ersten Schritt wird die Leiterplatte in das Hilfswerkzeug gelegt. Das Hilfswerkzeug ermöglicht die Justierung der Leiterplatte, so dass sie in einer ausgerichteten und reproduzierbar genauen Position im Hilfswerkzeug liegt. Diese Position entspricht dem späteren Montagezustand am Gehäuse-Träger 1 der Kamera. Anschließend wird der THD-Bildsensor in die Durchkontaktierungen des THD-Footprints der Leiterplatte 5 gesteckt. Durch das Hilfswerkzeug erfolgt eine Ausrichtung des THD-Bildsensors zur Leiterplatte 5 mittels der Referenzposition 15 in X-Richtung, der Referenzposition 19 in Y-Richtung und der Referenzposition 58 in Z-Richtung. Nach erfolgter Justierung des Bildsensors in Bezug auf die Leiterplatte 5 wird der Bildsensor fixiert und mit der Leiterplatte 5 verlötet.

Die Montage des THD-Bildsensors auf die Leiterplatte 5 als Bestandteil einer digitalen Industriekamera bei gleichzeitiger Anforderung einer möglichst fehlerfreien Ausrichtung der optisch sensitiven Fläche des Dies 16 zur optischen Bildebene 11 als Projektion der Objektebene 9 ist jedoch mit Nachteilen verbunden. Bildsensoren in einer THD-Gehäuseform werden standardmäßig auf einer Leiterplatte durch das Montageverfahren Löten befestigt.

Fig. 6 zeigt eine herkömmliche Bildsensor-Baugruppe mit Leiterplatte 5 und darauf festgelöteten Bauteilen, wie bspw. SMD-Bauteilen 20 und einem verlöteten THD-Bildsensor 21 in perspektivischer Ansicht (f) und Draufsicht (g). Während des Leiterplatten-Designs wird für den THD-Bildsensor 21 ein geeignetes THD-Footprint in die Leiterplatte 5 eingebracht. Das THD-Footprint weist THD-Durchkontaktierungen auf. Während der Montage wird der THD-Bildsensor 21 in die Löcher des THD-Footprints geführt und anschließend verlötet, wodurch THD-Lötstellen 22 entstehen. Die Verwendung eines THD-Footprints auf einer Bildsensor-Baugruppe weist jedoch folgende Nachteile auf:
- Durchkontaktierungen und durch die Leiterplatte 5 geführte Bildsensor-Drahtanschlüsse 13 führen im Vergleich zu einem Footprint für ein SMD-Bauteil zu zusätzlichem Platzverlust auf der Löt-Seite der Leiterplatte 5. Dies führt zu einem höheren Platzbedarf und dadurch zu größeren geometrischen Abmessungen der Leiterplatte 5, was wiederum zu höheren Leiterplatten-Kosten führt.
- Je nach verwendetem Lötverfahren können zusätzliche Montage-Freihaltungen 23 erforderlich sein. Hierbei handelt es sich um Bereiche auf der Löt-Seite des THD-Bildsensors 21, innerhalb derer keine weiteren Bauteile platziert werden dürfen. Solche Montagefreihaltungen 23 werden im Falle des Handlötens als Freiraum für den Lötkolben und im Falle des Wellenlötens als Freiraum für den Löttiegel benötigt. Die Freihaltungen 23 dieser Bereiche führt zu einem höheren Platzbedarf und dadurch zu größeren geometrischen Abmaßen der Leiterplatte 5, was wiederum zu höheren Leiterplatten-Kosten führt.
- Um der Anforderung einer möglichst fehlerfreien Ausrichtung des Bildsensors zur Leiterplatte Rechnung zu tragen, wird der THD-Bildsensor 21 zur Bildsensor-Baugruppe ausgerichtet, fixiert und anschließend verlötet. Die Ausrichtung und Fixierung erfolgt unter Verwendung eines Hilfswerkzeugs. Das Hilfswerkzeug muss für die jeweilige Bildsensor-Baugruppe produktspezifisch konstruiert werden, so dass bei einer geänderten Geometrie bzw. Abmessung der Bildsensor-Baugruppe oder bei einer geänderte Montageart der Bildsensor-Baugruppe am Gehäuse-Träger 1 oder bei einer geänderten Montageposition der Bildsensor-Baugruppe am Gehäuse-Träger 1 oder bei geänderten Vorgaben für die Ausrichtung des THD-Bildsensors 21 auf der Bildsensor-Baugruppe eine Neukonstruktion des Hilfswerkzeugs erforderlich ist (Änderung der Vorgaben für die Raumkoordinaten X, Y und Z bzw. den Bildsensor-Tilt). Die Neukonstruktion des Hilfswerkzeugs führt jedoch zu zusätzlichem Personal-, Herstellungs-, Material-, Kalibrier- und Prüfaufwand für das Hilfswerkzeug, sowie zu einer Verzögerung der Produkteinführung der digitalen Industriekamera aufgrund von Neukonstruktion, Herstellung, Kalibrierung und Evaluierung des Hilfswerkzeugs.

Wie im Folgenden erläutert wird, ist jedoch auch der Fertigungsablauf zur Verarbeitung eines THD-Bildsensors 21 auf der Bildsensor-Baugruppe mit Nachteilen verbunden.

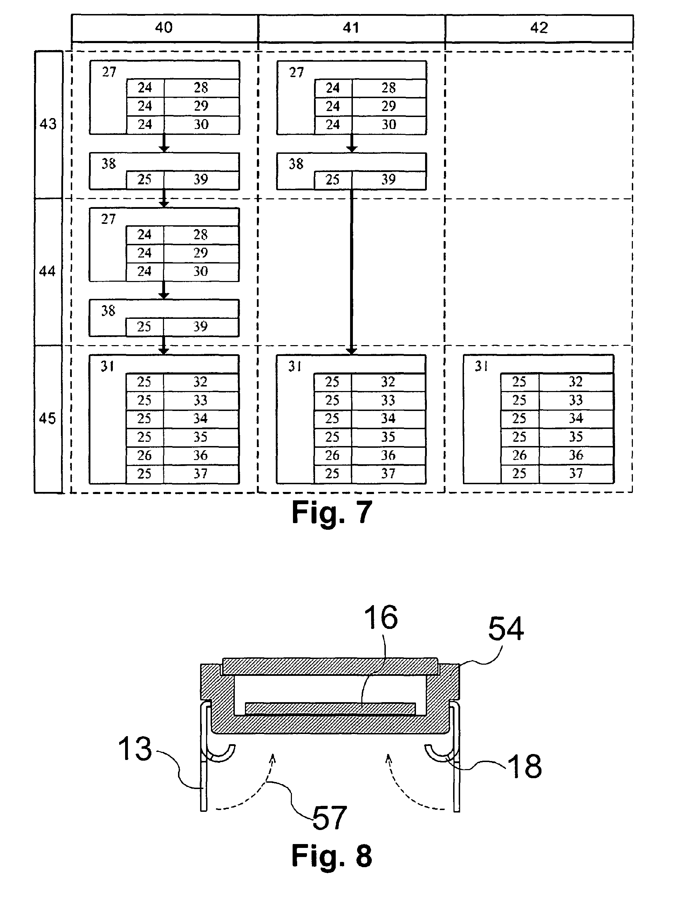

Fig. 7 zeigt eine tabellarische Auflistung der Fertigungs-Prozessabläufe zur Herstellung einer Baugruppe mit THD-Bildsensor. Gemäß Fig. 7 wird zwischen einem SMD-Fertigungsprozess 27 und einem THD-Fertigungsprozess 31 unterschieden. Der typische SMD-Fertigungsprozess 27 besteht aus einer Bepastung 28 der Bildsensor-Baugruppe mit Lotpaste, einer Bestückung 29 mit SMD-Bauteilen und einem anschließenden Reflow-Löten 30. Bei der Bepastung 28, der Bestückung 29 und dem Reflow-Löten 30 handelt es sich um automatisierte Fertigungsprozessschritte 24. Ein typischer THD-Fertigungsprozess 31 für den THD-Bildsensor besteht aus der Vorbereitung 32 der Drahtanschlüsse des THD-Bildsensors. Hierzu gehört z.B. das Kürzen der Bildsensor-Drahtanschlüsse 13. Anschließend wird der THD-Bildsensor auf der Bildsensor-Baugruppe platziert 33. Mittels Hilfswerkzeug erfolgt dann die Ausrichtung 34 und Fixierung 35 des THD-Bildsensors 21 auf der Leiterplatte der Bildsensor-Baugruppe. Danach wird der THD-Bildsensor per Handlöten oder Wellenlöten 36 mit der Leiterplatte verlötet. Im letzten Schritt wird das Hilfswerkzeug von der Bildsensor-Baugruppe entfernt 37. Bei der Vorbereitung 32 der Drahtanschlüsse des THD-Bildsensors, der Platzierung 33 auf der Bildsensor-Baugruppe, der Ausrichtung 34 und Fixierung 35 mittels Hilfswerkzeug sowie der Entfernung 37 des Hilfswerkzeugs nach erfolgter Lötung handelt es sich um manuelle Fertigungsprozessschritte 25. Lediglich der eigentliche Lötvorgang 36 kann als manueller oder automatisierter Fertigungsprozessschritt 26 ausgeführt werden. Bei Verwendung des Fertigungsverfahrens Wellen löten wird der Lötvorgang zum automatisierten Fertigungsprozessschritt 24. Im Falle von Handlöten handelt es sich um einen manuellen Fertigungsprozessschritt 25.

Gemäß Fig. 7 gibt es unterschiedlich ausgeführte Bestückungsvarianten einer Bildsensor-Baugruppe. So unterscheidet man bei den mischbestückten Bildsensor-Baugruppen zwischen der einseitig SMD-bestückten Baugruppe 41 und der beidseitig SMD-bestückten Baugruppe 40. Im Falle der einseitig SMD-bestückten Bildsensor-Baugruppe 41 wird zur Bestückung der ersten SMD-Bearbeitungsseite 43 der SMD-Fertigungsprozess 27 einmal durchlaufen. Im Falle einer beidseitig SMD-bestückten Bildsensor-Baugruppe 40 wird der SMD-Fertigungsprozess 27 jeweils einmal für die erste SMD-Bearbeitungsseite 43 und einmal für die zweite SMD-Bearbeitungsseite 44 durchlaufen. Bei einer Bildsensor-Baugruppe, bei welcher alle Bauteile THD-Bauteile, also auch der THD-Bildsensor 21 sind, spricht man von einer reinen THD-Baugruppe 42. Hierbei entfallen alle SMD-Bearbeitungsschritte. Da die mischbestückten Bildsensor-Baugruppen 40 und 41 mehrere Fertigungsprozessschritte beinhalten, fallen zwischen den Fertigungsprozessschritten sonstige Fertigungsprozessschritte 38 an. Hierbei handelt es sich um die Zwischenlagerung 39 der teilmontierten Bildsensor-Baugruppe. Bei diesem manuellen Arbeitsgang 25 werden die teilmontierte Bildsensor-Baugruppen z.B. in Kisten für den nächsten Fertigungsschritt bereitgestellt.

Durch die Verarbeitung des THD-Bildsensors im (Standard-)THD-Fertigungsprozess ergeben sich Nachteile dahingehend, dass der THD-Fertigungsprozess 31 überwiegend aus manuellen Fertigungsprozessschritten 25 besteht, die teuer sind und sich bis auf den eigentlichen THD-Lötprozess 36 nur mit hohem Aufwand automatisieren lassen. Das führt zu höherem Herstellungsaufwand gegenüber einem automatisierten Prozess. Ferner beinhaltet der THD-Fertigungsprozess 31 gegenüber einem SMD-Fertigungsprozess 27 viele einzelne Teilschritte. Eine große Anzahl an Teilschritten führt aber zu einem höheren Herstellungsaufwand gegenüber einer geringeren Anzahl. Die Kombination aus SMD-Fertigungsprozess 27 und nachfolgendem THD-Fertigungsprozess 31 führt gegenüber einem reinen SMD-Fertigungsprozess 27 zu längeren Fertigungszeiten und somit wiederum zu höherem Herstellungsaufwand. Bei den sonstigen Fertigungsprozessschritten 38 handelt es sich generell um nicht wertschöpfende, manuelle Fertigungsprozessschritte 25. Zwischen dem letzten SMD- Fertigungsprozess 27 und dem THD-Fertigungsprozess 31 zur Verarbeitung des THD- Bildsensors ist ein solcher sonstigen Fertigungsprozessschritt 38 erforderlich, welcher ebenfalls zu einem erhöhten Herstellungsaufwand für die Bildsensor-Baugruppe führt.

### Zusammenfassung der Erfindung:

Der Erfindung liegt die Aufgabe zugrunde eine Bildsensor-Baugruppe sowie ein Herstellungsverfahren und -hilfsmittel bereitzustellen, durch die geringere Abmessungen, eine effizientere Fertigung und eine höhere Prozesssicherheit und Reproduzierbarkeit ermöglicht werden.

Diese Aufgabe wird erfindungsgemäß gelöst durch eine Bildsensor-Baugruppe nach Anspruch 1, ein Herstellungsverfahren nach Anspruch 8 und ein Biegewerkzeug nach Anspruch 12.

Dementsprechend wird ein modifizierter THD-Bildsensor bereitgestellt, dessen Drahtanschlüsse mittels eines angepassten Biegewerkzeugs so modifiziert sind, dass die Draht-anschlüsse nicht durch die Leiterplatte durchgesteckt und verlötet werden müssen und dass sie eine Referenz zu einer optisch sensitiven Fläche des Bildsensors bilden. Der modifizierte THD-Bildsensor kann somit in einem SMD-Fertigungsprozess bestückt werden. Somit können die oben beschriebenen technischen Mängel bei der Montage des modifizierten THD-Bildsensors auf einer Leiterplatte (z.B. als Bestandteil einer digitalen Industriekamera) bei gleichzeitiger Anforderung einer möglichst fehlerfreien Ausrichtung der optisch sensitiven Fläche des Bildsensor-Dies durch die Erfindung auf vorteilhafte Weise behoben werden. Insbesondere kann die Anzahl der Prozessschritte und damit der Herstellungsaufwand gesenkt werden, da die Ausrichtung und Modifikation des THD-Bildsensors in einem einzigen kombinierten Prozessschritt durchführbar ist. Der modifizierte THD-Bildsensors kann also in einem SMD-Fertigungsprozess montiert werden, wobei das Herstellungsverfahren die Teilaspekte Modifikation des THD-Bildsensors und Verarbeitung des modifizierten THD-Bildsensors im SMD-Fertigungsprozess umfasst. Vorzugsweise können die modifizierten Drahtanschlüsse des Bildsensors J-förmig ausgebildet sind. Sie können aber auch eine Gull-Wing-Form oder eine andere zur Oberflächenmontage geeignete Form aufweisen.

Im Zusammenhang mit der vorliegenden Erfindung ist unter dem Begriff "Biegen" jeder umformende Fertigungsschritt bzw. jedes umformende Fertigungsverfahren zu verstehen, bei denen ein Ausgangsmaterial durch Modifikation einer Formänderung unterzogen wird. Die Art der Modifikation kann je nach Verfahren variieren. Übliche technische Verfahren sind z.B. das mechanische Biegen oder das Biegen mittels Laser. Beim mechanischen Biegen wird eine Kraft in Form eines mechanischen Biegemoments auf das Ausgangsmaterial ausgeübt. Diese Kraft führt zu einer plastischen Verformung. Beim Biegen mittels Laser wird das Ausgangsmaterial mittels Laser lokal kurzzeitig erwärmt. Die Erwärmung und anschließende Abkühlung des Materials führt zu Verspannungen innerhalb des Materials, die dann ebenfalls zu einer plastischen Verformung führt.

Gemäß einer vorteilhaften Weiterbildung können die modifizierten Drahtanschlüsse des Bildsensors unterschiedliche Längen aufweisen, so dass eine vorbestimmte Neigung des Bildsensors gegenüber einer Objektebene der Kamera erreichbar ist.

Gemäß einer weiteren vorteilhaften Weiterbildung kann die Länge der modifizierten Drahtanschlüsse des Bildsensors in Abhängigkeit eines optischen Filters im Strahlengang der Kamera gewählt sein.

Gemäß einer noch weiteren vorteilhaften Weiterbildung kann die Leiterplatte auf der Oberfläche ein Anschlussmuster aufweisen, das für jeden modifizierten Drahtanschluss des Bildsensors eine elektrisch leitende Kontaktfläche zur Oberflächenmontage aufweist.

Des Weiteren kann die erfindungsgemäße Bildsensor-Baugruppe an einem Kameragehäuseträger einer digitalen Industriekamera fixiert sein.

Gemäß einer vorteilhaften Weiterbildung des Herstellungsverfahrens können ein Ausrichten und Fixieren des Bildsensors und ein Durchführen des Biegevorgangs in Abhängigkeit der Lage der optisch sensitiven Fläche des Bildsensors vorgesehen sein.

Vorzugsweise kann die Ausrichtung unter Verwendung zumindest eines mechanischen Anschlags zur Festlegung zumindest einer Referenzposition erfolgen, wobei das Fixieren durch mechanisches Klemmen des Bildsensorgehäuses gegen ein Biegewerkzeug erfolgen kann. Hierfür können die Ausrichtungsmittel des Biegewerkzeugs zumindest einen mit einer Referenzposition für die optisch sensitive Fläche des Bildsensors verknüpften mechanischen Anschlag aufweisen. Die Fixierungsmittel können zumindest zwei Klemmbacken aufweisen.

Als vorteilhafte Alternative kann die Ausrichtung auch basierend auf einer optischen Vermessung der optisch sensitiven Fläche des Bildsensors erfolgen. Hierfür können die Ausrichtungsmittel des Biegewerkzeugs ein Optisches Messsystem aufweisen, welches die Lage der optisch sensitiven Fläche des Bildsensors innerhalb des Bildsensorgehäuses erfasst.

Schließlich kann die Modifizierung der ursprünglichen Drahtanschlüsse vorzugsweise auch zur Korrektur von Toleranzwerten in zumindest einer Raumrichtung herangezogen werden.

### Kurzbeschreibung der Zeichnunqsfiquren:

Bevorzugte Ausführungsformen der Erfindung werden im Folgenden anhand der beiliegenden Figuren näher erläutert. Es zeigen:
Fig. 1 schematische Prinzipdarstellung einer digitalen Industriekamera mit Funktionseinheiten;
Fig. 2 einen beispielhaften Aufbau einer Industriekamera;
Fig. 3 eine schematische Darstellung des Zusammenhangs zwischen Objektebene und Bildebene;
Fig. 4 verschiedene Ansichten eines Bildsensors mit THD-Gehäuseform;
Fig. 5 eine Schnittansicht und Draufsicht einer Industriekamera mit Projektionsverlauf;
Fig. 6 eine herkömmliche THD Bildsensor-Baugruppe mit Leiterplatte und gelöteten Bauteilen;
Fig. 7 eine tabellarische Übersicht der Fertigungs-Prozessabläufe zur Herstellung herkömmlicher Bildsensor-Baugruppen mit THD-Bildsensor;
Fig. 8 eine beispielhafte Modifikation der Drahtanschlüsse eines THD-Bildsensors gemäß einem ersten Ausführungsbeispiel;
Fig. 9 eine beispielhafte Modifikation der Drahtanschlüsse eines THD-Bildsensors gemäß dem ersten Ausführungsbeispiel mit Korrektur von Toleranzwerten in x-Richtung;
Fig. 10 eine beispielhafte Modifikation der Drahtanschlüsse eines THD-Bildsensors gemäß dem ersten Ausführungsbeispiel mit Korrektur von Toleranzwerten in y-Richtung;
Fig. 11 eine beispielhafte Modifikation der Drahtanschlüsse eines THD-Bildsensors gemäß dem ersten Ausführungsbeispiel mit Korrektur von Toleranzwerten in z-Richtung;
Fig. 12 eine beispielhafte Modifikation der Drahtanschlüsse eines THD-Bildsensors gemäß einem zweiten Ausführungsbeispiel zum Ausgleich unterschiedlicher optischer Wegstrecken;
Fig. 13 eine beispielhafte Modifikation der Drahtanschlüsse eines THD-Bildsensors gemäß einem dritten Ausführungsbeispiel zur Neigungskompensation;
Fig. 14 eine beispielhafte Bestückung des THD-Bildsensors gemäß dem ersten Ausführungsbeispiel auf einer Leiterplatte;
Fig. 15 eine tabellarische Übersicht der Fertigungs-Prozessabläufe zur Herstellung von Bildsensor-Baugruppen mit modifiziertem THD-Bildsensor gemäß den Ausführungsbeispielen;
Fig. 16 eine schematische Darstellung eines Biegewerkzeug gemäß einem ersten Ausführungsbeispiel mit mechanischen Ausrichtung des THD-Bildsensors; und
Fig. 17 eine schematische Darstellung eines Biegewerkzeug gemäß einem zweiten Ausführungsbeispiel mit optischer Ausrichtung des THD-Bildsensors.

### Detaillierte Beschreibung der Ausführungsbeispiele:

Gemäß den nachfolgenden Ausführungsbeispielen wird eine Bildsensor-Baugruppe mit modifiziertem THD-Bildsensor beschrieben. Die Modifikation des THD-Bildsensors umfasst die Schritte des Ausrichtens und Fixierens des THD-Bildsensors am Biegewerkzeug und des Modifizierens der Drahtanschlüsse des THD-Bildsensors.

Um eine optimale Ausrichtung des modifizierten THD-Bildsensors zur Leiterplatte durch den nachfolgenden SMD-Fertigungsprozess zu ermöglichen, erfolgt die Modifikation der Drahtanschlüsse bspw. in Abhängigkeit der Lage der optisch sensitiven Fläche des Bildsensor-Dies. Aus diesem Grund wird der THD-Bildsensor vor der Modifikation zum Biegewerkzeug im dreidimensionalen Raum ausgerichtet und nach Ausrichtung im Biegewerkzeug fixiert. Die Ausrichtung des THD-Bildsensors zum Biegewerkzeug kann mechanisch oder optisch erfolgen.

Bei der mechanischen Ausrichtung während des Herstellungsprozesses wird die optisch sensitive Fläche des Bildsensor-Dies zu den von außen zugänglichen Bildsensor-Referenzpositionen in X-Richtung, Y-Richtung und Z-Richtung ausgerichtet. Dabei können die Bildsensor-Referenzpositionen des THD-Bildsensors in X-Richtung, Y-Richtung und Z-Richtung als mechanischer Anschlag genutzt werden und der THD-Bildsensor kann über diese Positionen zum Werkzeug ausgerichtet werden. Durch ein flächiges Auflegen des Bildsensor-Gehäuses in Z-Richtung kann der Bildsensor-Tilt vermieden werden. Nach der Ausrichtung des THD-Bildsensors zum Biegewerkzeug wird der THD-Bildsensor im Biegewerkzeug mechanisch fixiert. Ein Beispiel für eine mögliche Fixierung ist das mechanische Klemmen des Bildsensor-Gehäuses gegen das Biegewerkzeug. Fig. 8 zeigt eine beispielhafte Modifikation der Drahtanschlüsse 13 eines THD-Bildsensors 54 gemäß einem ersten Ausführungsbeispiel bei optischer Ausrichtung des THD-Bildsensors 54 zum Biegewerkzeug (nicht gezeigt). Obwohl die optisch sensitive Fläche des Dies 16 des THD-Bildsensors 54 während des Herstellungsprozesses zu den von außen zugänglichen Bildsensor-Referenzpositionen in X-Richtung, Y-Richtung und Z-Richtung ausgerichtet, fixiert und festmontiert wird, unterliegt dieser Herstellungsprozess gewissen Toleranzen. Typische Toleranzwerte für die X-, Y- und Z-Richtung sind +/-100pm, für die Rotation +/-1Grad und für den Tilt +/-0.5 Grad. Um gegenüber der mechanischen Ausrichtung noch höhere Genauigkeiten bei der Ausrichtung des THD-Bildsensors 54 zum Biegewerkzeug zu erreichen, ist es möglich, anstelle der mechanischen Anschläge, die Position der optisch sensitiven Fläche des Bildsensor-Dies 16 im dreidimensionalen Raum direkt zu vermessen. Die Messung kann mittels eines optischen Systems erfolgen, welches die Position der optisch sensitiven Fläche des Bildsensor-Dies 16 durch das Deckglas hindurch ermittelt und entsprechend dem Messergebnis eine Ausrichtung des THD-Bildsensors 54 zum Biegewerkzeug im dreidimensionalen Raum vornimmt. Nach der Ausrichtung des THD-Bildsensors zum Biegewerkzeug wird der THD-Bildsensor im Biegewerkzeug mechanisch fixiert.

Nach der Ausrichtung und Fixierung des THD-Bildsensors 54 zum Biegewerkzeug erfolgt die Modifikation der Bildsensor-Drahtanschlüsse 13. Ein Beispiel einer möglichen Modifikation ist in Fig. 8 dargestellt. Mittels des Biegewerkzeugs wird hierbei eine im Wesentlichen kreisförmige Biege-Bewegung 57 auf einer Kreisbahn ausgeführt. Hierdurch werden die ursprünglich geformten Bildsensor-Drahtanschlüsse 13 in modifizierte Bildsensor-Drahtanschlüsse 18 umgeformt. Im Falle von Fig. 8 führt die Modifikation durch die dargestellte Biegebewegung 57 zu einem modifizierten THD-Bildsensor 54 mit sogenannten J-förmigen Drahtanschlüssen 18, wie sie bspw. in IPC J-STD-001 D DE, "Anforderungen an gelötete elektrische und elektronische Baugruppen", Februar 2005, Kapitel 7.6.9, Seite 27 beschrieben sind.

Wie mehrfach erläutert, wird bei Bildsensoren mit einer THD-Gehäuseform die optisch sensitive Fläche des Bildsensor-Dies 16 während der Herstellung des THD-Bildsensors zu von außen zugänglichen Referenzpositionen in X-Richtung, Y-Richtung und Z-Richtung justiert und im Inneren des Bildsensor-Gehäuses fest montiert. Der Bezug zwischen der optisch sensitiven Fläche des Bildsensor-Dies 16 und der Position der Bildsensor-Drahtanschlüsse 13 ist hierbei für den Bildsensor-Hersteller zweitrangig, da die Ausrichtung, Fixierung und Lötung des herkömmlichen THD-Bildsensors auf einer Bildsensor-Baugruppe standardmäßig mittels Hilfswerkzeug erfolgt. Somit unterliegt die Position der Bildsensor-Drahtanschlüsse 13 in Bezug auf die optisch sensitive Fläche des Bildsensor-Dies 16 meist gewissen Toleranzen. Typische Toleranzwerte für die X- und Y-Richtung sind mit +/-100µm auf nachteilige Weise zu hoch. Um eine optimale Ausrichtung des modifizierten THD-Bildsensors 54 zur Leiterplatte durch einen nachfolgenden SMD-Fertigungsprozess zu ermöglichen, sind genau diese zu hohen Toleranzwerte durch den Biegeprozess nachteilig.

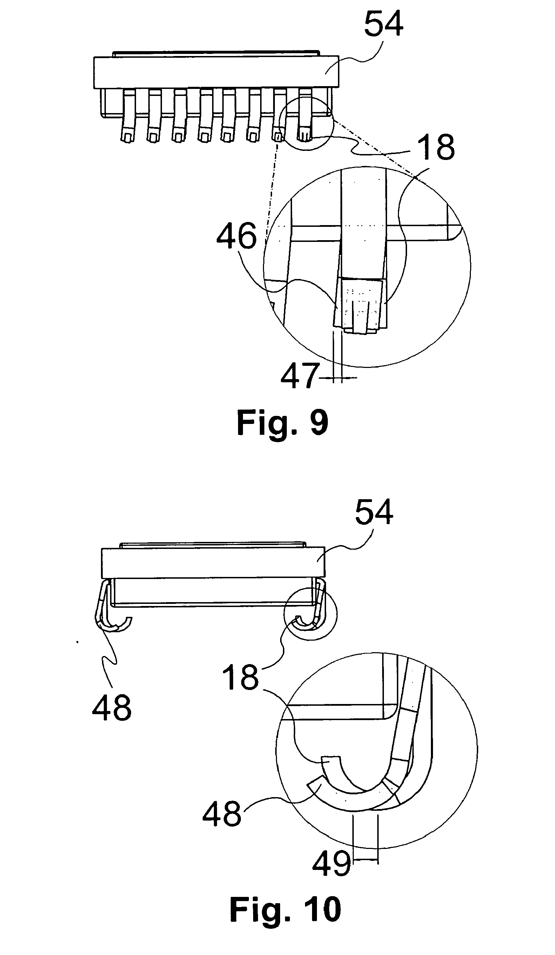

Im Folgenden werden beispielhafte Korrekturen unerwünschter Toleranzen anhand der Figuren 9, 10 und 11 erläutert. Dort wird ein modifizierter Bildsensor 54 mit modifizierten Drahtanschlüssen 18 aus verschiedenen Blickrichtungen gezeigt.

Fig. 9 zeigt eine Modifikation der Drahtanschlüsse des modifizierten THD-Bildsensors gemäß dem ersten Ausführungsbeispiel mit Korrektur der Toleranzwerte in X-Richtung. Hier erfolgt die Korrektur des Toleranzwerts für die X-Richtung durch seitliches Biegen eines toleranzbehafteten modifizierten Drahtanschlüsse 46 gegenüber einem modifizierten Drahtanschluss 18, bei dem keine Korrektur des Toleranzwertes notwendig ist. Als Ergebnis wird die Lage der optisch aktiven Fläche des Bildsensor-Dies 16 in Bezug auf den Lötbereich der modifizierten Drahtanschlüsse 18 um einen Korrekturwert 47 in X-Richtung, der hier als ΔX bezeichnet wird, korrigiert.

Fig. 10 zeigt eine Modifikation der Drahtanschlüsse des modifizierten THD-Bildsensors gemäß dem ersten Ausführungsbeispiel mit Korrektur der Toleranzwerte in X-Richtung. Hier erfolgt die Korrektur des Toleranzwertes für die Y-Richtung durch seitliches Biegen eines toleranzbehafteten modifizierten Drahtanschlusses 48 gegenüber einem modifizierten Drahtanschluss 18, bei dem keine Korrektur des Toleranzwertes notwendig ist. Als Ergebnis wird die Lage der optisch aktiven Fläche des Bildsensor-Dies 16 in Bezug auf den Lötbereich der modifizierten Drahtanschlüsse 18 um einen Korrekturwert 49 in Y-Richtung, der hier als ΔY bezeichnet wird, korrigiert.

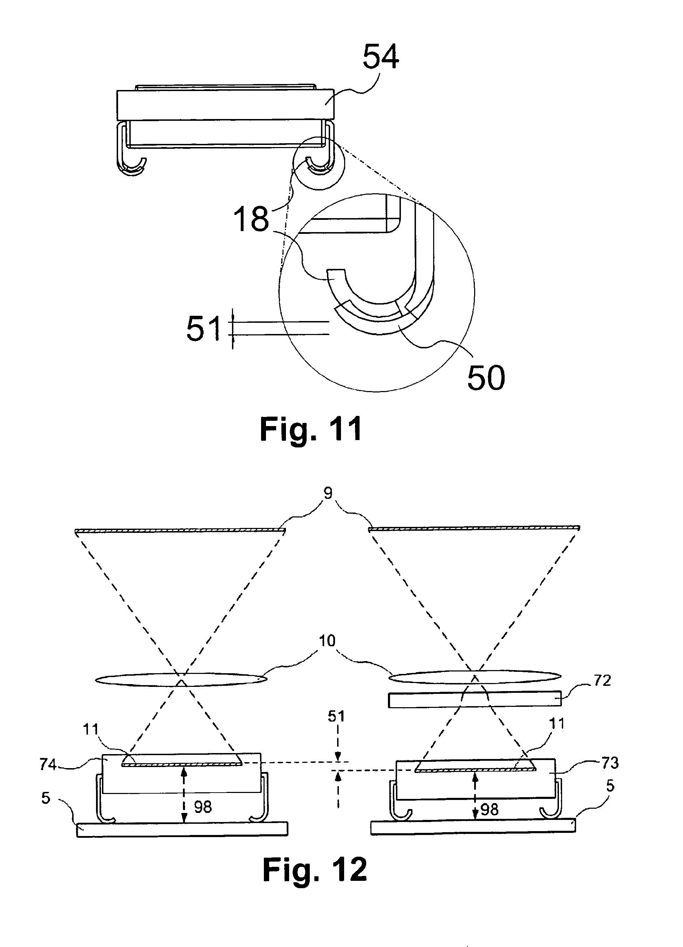

Fig. 11 zeigt eine Modifikation der Drahtanschlüsse des modifizierten THD-Bildsensors gemäß dem ersten Ausführungsbeispiel mit Korrektur der Toleranzwerte in Z-Richtung. Hier erfolgt die Korrektur des Toleranzwertes für die Z-Richtung durch Veränderung der Drahtanschlusslänge eines toleranzbehafteten modifizierten Drahtanschlusses 50 gegenüber einem modifizierten Drahtanschluss 18, bei dem keine Korrektur des Toleranzwertes notwendig ist. Als Ergebnis wird die Lage der optisch aktiven Fläche des Bildsensor-Dies 16 in Bezug auf den Lötbereich der modifizierten Drahtanschlüsse 18 um einen Korrekturwert 51 in Z-Richtung, der hier als ΔZ bezeichnet ist, korrigiert.

Für die Korrektur der Toleranzwerte der modifizierten Bildsensor-Drahtanschlüsse 18 in Bezug auf die optisch sensitive Fläche des Bildsensor-Dies 16 lässt sich bspw. auch eine Gesamtkorrektur im dreidimensionalen Raum, also für die X-, Y- und Z-Richtung, die Rotation und den Tilt, aus den Korrekturwerten 47 (ΔX), 49 (ΔY) und 51 (ΔZ) zusammensetzen.

Als Ergebnis der Modifikation ergibt sich somit ein modifizierter Bildsensor 54, dessen modifizierte Bildsensor-Drahtanschlüsse 18 als Referenz-Position in Bezug auf die optisch sensitiven Fläche des Bildsensor-Dies 16 dienen. Für die Modifikation der ursprünglichen Bildsensor-Drahtanschlüsse 13 kann ein universelles Biegewerkzeug zum Einsatz kommen, welches die Biegeaufgabe unabhängig von den Gegebenheiten auf der späteren Bildsensor-Baugruppe erfüllen kann. Durch die Verwendung des universellen Biegewerkzeugs ergeben sich gegenüber mehreren auf die jeweilige Bildsensor-Baugruppe angepassten Hilfswerkzeugen Vorteile dahingehend, dass nur eine einmalige Konstruktionsaufgabe (anstelle immer wiederkehrende Konstruktionsaufgabe) und damit ein geringer Herstellungsaufwand anfällt, da das universelle Biegewerkzeug produktübergreifend eingesetzt werden kann. Zudem können der Material-, Wartungs-, Evaluierungs- und Ersatzteilaufwand verringert werden, da anstelle vieler verschiedener angepasster Hilfswerkzeuge nur ein universelles Biegewerkzeug eingerichtet, gewartet, getestet und repariert werden muss. Dies führt auch zu einer schnelleren Produkt-Entwicklung und somit einem schnelleren Markteinstieg (Time-To-Market) für die digitale Industriekamera, da nach einmaliger Fertigstellung des universellen Biegewerkzeugs für alle nachfolgenden Produkte diese Konstruktionsaufgabe im Rahmen der Produktentwicklung entfällt.

Neben der Korrektur von Toleranzwerten können durch gezielte Variationen der Korrekturwerte bzw. Wegstrecken ΔX, ΔY und ΔZ weitere Anwendungsgebiete erschlossen werden.

So kann bspw. gemäß einem ersten Beispiel eine Variation von ΔZ zum Ausgleich optischer Wegdifferenzen eingesetzt werden. Bildsensoren werden generell in Monochrom-Bildsensoren und Farb-Bildsensoren unterschieden. Während monochrome Bildsensoren einfallendes Licht in unbunte Abbildungen konvertieren, erzeugen Farb-Bildsensoren ein Abbild, welches sich aus den mehreren Farben, z.B. Rot, Grün und Blau, zusammensetzt. Dafür benötigt der Bildsensor eine Vielzahl von Farbmasken, die in vorgegebenen Teilen des sichtbaren Wellenlängenbereichs transparent sind. Da die derzeit verfügbaren Farbmasken auch im nahinfraroten Wellenlängenbereich transparent sind, kann zur Vermeidung von nachteiligen Farbfehlern ein sogenannter Infrarot-Sperrfilter erforderlich sein, welcher verhindert, dass Licht aus dem nahinfraroten Wellenlängenbereich auf die lichtempfindliche Fläche des Sensors gelangt. Da Monochrom-Bildsensoren keine Farbunterscheidung vornehmen, besteht kein Problem eines nachteiligen Farbfehlers und somit kann auf den nicht notwendigen Infrarot-Sperrfilter verzichtet werden. Aus beispielsweise diesem Grund werden in digitalen Industriekameras mit Farb-Bildsensoren häufig optische Filter, z.B. Infrarot-Sperrfilter, eingesetzt.

Fig. 12 zeigt eine schematische Darstellung einer beispielhaften Modifikation der Draht-anschlüsse eines THD-Bildsensors gemäß einem zweiten Ausführungsbeispiel zum Ausgleich unterschiedlicher optischer Wegstrecken bei Verwendung von Infrarot-Sperrfiltern (IR-Cut-Filtern). Wie in Fig. 12 zu sehen ist, wird ein Originalebene 9 mittels eines Linsensystems 10 auf die Bildebene 11 projiziert, welche deckungsgleich zur optisch sensitiven Fläche des Bildsensor-Dies ausgerichtet ist. Wird nun im Falle eines Farb-Bildsensors 73 ein Infrarot-Sperrfilter 72 in den optischen Strahlengang eingefügt, ergibt sich durch den Brechungsindex des Infrarot-Sperrfilters 72 eine Verschiebung der Bildebene gegenüber einem Monochrom-Bildsensor 74, der keinen Infrarot-Sperrfilter 72 aufweist. Dieser Unterschied der Position der Bildebene führt zu einer optischen Weglängendifferenz (ΔZ) 51.

Bei der Verarbeitung des THD-Bildsensors kann nun diese unerwünschte optische Weglängendifferenz (ΔZ) 51 als Verschiebung der Bildebene auf konstruktive Weise ausgeglichen werden. Ein Beispiel hierfür ist die Konstruktion und Herstellung mehrerer unterschiedlicher Hilfswerkzeuge für Bildsensoren mit und ohne Verwendung eines Infrarot-Sperrfilters 72. Ein weiteres Beispiel für eine konstruktive Maßnahme ist die Konstruktion und Herstellung unterschiedlicher Kamera-Gehäuseträger, die bei der Befestigung der Bildsensor-Baugruppe ebenfalls die Weglängendifferenz (ΔZ) 51 ausgleichen können. Beide konstruktiven Maßnahmen führen jedoch zu nachteiligen Kosten, weil die Anzahl der benötigten Hilfswerkzeuge bzw. Kamera-Gehäuseträgertypen vergrößert ist. Durch die erfindungsgemäße Modifikation der Bildsensor-Drahtanschlüsse und die nachträgliche Verarbeitung in einem SMD-Fertigungsprozess lassen sich gemäß Fig. 12 die unterschiedlichen Positionen der Bildebene und die sich daraus ergebene Weglängendifferenz (ΔZ) 51 durch Variation der Länge der auf der Leiterplatte 5 befestigten modifizierten Bildsensor-Drahtanschlüsse ausgleichen. So werden für den Monochrom-Bildsensor 74 modifizierte Bildsensor-Drahtanschlüsse gebogen, welchen gegenüber den modifizierten Bildsensor-Drahtanschlüsse des Farb-Bildsensors 73 bei Verwendung eines Infrarot-Sperrfilters 72 um den Betrag der Weglängendifferenz (ΔZ) 51 länger sind. Hierdurch ergibt sich eine Änderung des Abstandes 98 zwischen der Bildebene und der Oberseite der Leiterplatte 5 um den Betrag der Weglängendifferenz (ΔZ) 51.

Gemäß einem zweiten Beispiel kann eine Variation des Bildsensor-Tilts und ΔZ zum Ausgleich eines schrägen Betrachtungs- oder Blickwinkels eingesetzt werden. In der Praxis tritt nämlich gelegentlich der Fall auf, dass man sich mit einer digitalen Industriekamera sehr dicht an einem großen Objekt befindet. Als Beispiel sei hier ein Hochhaus genannt. Befindet man sich nun mit der digitalen Industriekamera in einer Position mit schrägem Blickwinkel, z.B. zu ebener Erde, so muss man die Industriekamera so schwenken, dass das gesamte Objekt im Sichtbereich der Industriekamera liegt.

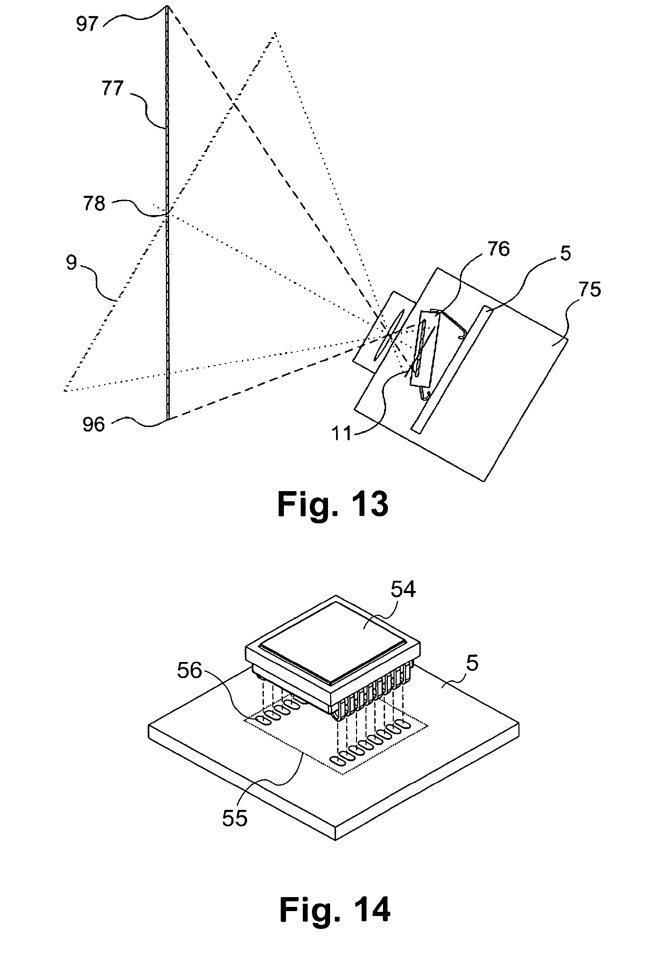

Fig. 13 zeigt eine schematische Darstellung einer beispielhaften Modifikation der Draht-anschlüsse eines THD-Bildsensors gemäß einem dritten Ausführungsbeispiel in einer Industriekamera 75 mit unterschiedlichen optischen Wegstrecken beim Anwendungsfall Hochhaus. Durch das Schwenken der digitalen Industriekamera 75 würde im Standardfall eine zur Blickrichtung orthogonal stehende Objektebene 9 auf eine Bildebene 11 projiziert. Hierbei stimmt die orthogonal stehende Objektebene 9 nicht mit der tatsächlichen Objektebene 77 überein. Diese Schiefstellung hat im Abbild zur Folge, dass nur ein kleiner Bereich, den man als Schärfepunkt 78 bezeichnen kann, die notwendige Bildschärfe aufweist. Alle anderen Bereiche der tatsächlichen Objektebene 77 werden auf nachteilige Weise im Abbild unscharf wiedergegeben. Ursache für diese Unschärfe sind optisch unterschiedlich lange Wegstrecken. Während sich die optische Wegstrecke zwischen dem unteren Ende 96 der Objektebene 77 und der Bildebene 11 als kurz charakterisieren lässt, ergibt sich für die optische Wegstrecke zwischen dem obersten Ende 97 der Objektebene 77 und der Bildebene 11 eine optisch lange Wegstrecke. Der Unterschied der beiden optischen Wegstrecken kann nun durch eine bewusst herbeigeführte Variation des Tilt bzw. der Neigung des THD-Bildsensors 76 kompensiert werden. Im konkreten Fall von Fig. 13 wird die eine Reihe der Bildsensor-Drahtanschlüsse mit größerem Abstand zur Leiterplatte 5 als die andere Reihe der Bildsensor-Drahtanschlüsse gebogen. Durch diese unterschiedlich langen Drahtanschlüsse ergibt sich ein bewusst herbeigeführter und als vorteilhaft wirkender Bildsensor-Tilt, welcher die unterschiedlich langen optischen Wegstrecken ausgleicht, so dass die gesamte tatsächliche Objektebene 77 in vorteilhafter Weise auf die optisch sensitive Fläche des Bildsensor-Dies scharf abgebildet wird. Durch den Bildsensor-Tilt ergibt sich aber auch eine Verschiebung des Zentrums der optisch sensitiven Fläche des Bildsensor-Dies und somit ein Bildsensor-Versatz in Y-Richtung. Zur Korrektur dieses Versatzes können die Bildsensor-Drahtanschlüsse mit einer Korrektur in Y-Richtung gebogen werden, so dass das Zentrum der optisch sensitiven oder aktiven Fläche des Bildsensor-Dies wieder der Position des Standard-Falles entspricht.

Durch die modifizierten Drahtanschlüsse für die Weglängendifferenz in Y-Richtung und den Bildsensor-Tilt kann ein speziell angepasster modifizierter Bildsensor 76 bereitgestellt werden, der auf einer Leiterplatte 5 der Bildsensor-Baugruppe die technischen Nachteile einer Unschärfe im Abbild beseitigen kann. Diese Lösung ist aus vorgenannten Gründen vorteilhaft gegenüber der Verwendung eines speziellen Hilfswerkszeugs.

Durch Modifikation der Bildsensor-Drahtanschlüsse wird somit wiederum eine Referenz zur optisch sensitiven Fläche des Bildsensor-Dies gebildet. Ferner ist es durch diese Maßnahmen im weiteren Verlauf möglich, den modifizierten THD-Bildsensor in einem SMD-Fertigungsprozess zu verarbeiten.

Fig. 14 zeigt eine schematische Darstellung der Bestückung des modifizierten THD-Bildsensors 54 auf einer Leiterplatte 5. Als vorbereitende Maßnahme ist auf der Leiterplatte 5 der Bildsensor-Baugruppe ein SMD-Anschlussmuster (SMD-Footprint) 55 vorgesehen. Dieses Anschlussmuster 55 besteht hier aus einer Kupferanschlussfläche (Kupferpad) 56 für jeden modifizierten Bildsensor-Drahtanschluss. Die Kupferanschlussflächen 56 weisen keine Löcher auf und befinden sich in Bezug auf die Leiterplatte 5 auf der Montageseite des modifizierten Bildsensors 54.

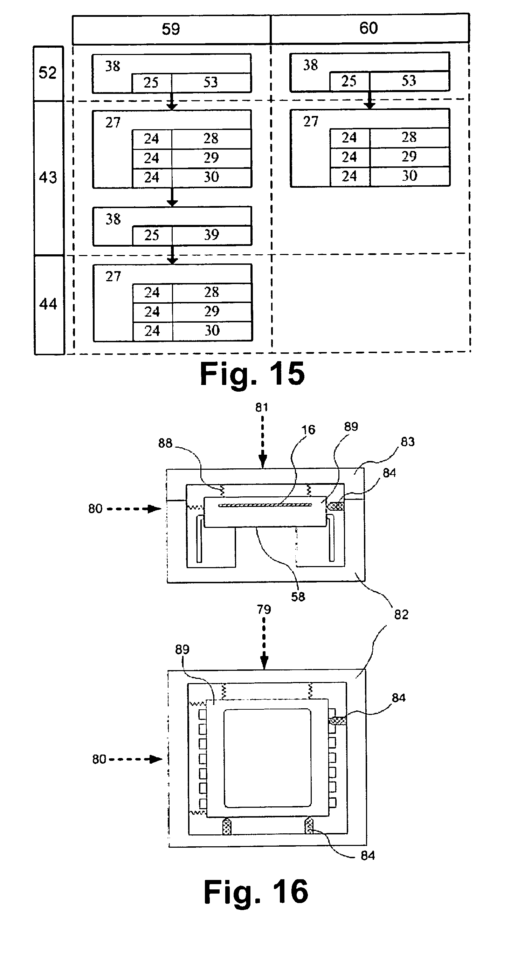

Fig. 15 zeigt eine tabellarische Übersicht der Fertigungsabläufe bei Verarbeitung des modifizierten THD-Bildsensors. Im Vergleich zu Fig. 7 zeigt Fig. 15 nun eine sehr viel schlankere Fertigungsprozessabfolge. Der modifizierte Bildsensor kann aufgrund der Modifikationen nun im SMD-Fertigungsprozess 27 verarbeitet werden. Da der THD-Bildsensor häufig das einzige THD-Bauteil der Bildsensor-Baugruppe ist, entfallen damit alle THD-Fertigungsprozesse und auch die Bestückungsvariante einer ausschließlich mit THD-Bauteilen bestückten Bildsensor-Baugruppe. Aus der Bestückungsvariante mischbestückte Baugruppe mit einseitig bestückten SMD-Bauteilen wird dann eine Bestückungsvariante mit einseitig bestückten SMD-Bauteilen 60. In äquivalenter Weise trifft dies auf die Bestückungsvarianten einer mischbestückten Baugruppe mit beidseitig bestückten SMD-Bauteilen zu, welche nun zu einer Bestückungsvariante mit beidseitig bestückten SMD-Bauteilen 59 wird. Durch die Verarbeitung des modifizierten Bildsensors ist es also möglich auf sämtliche Fertigungsprozesse zu verzichten, die mit der THD-Verarbeitung des THD-Bildsensors verbunden sind.

Gemäß Fig. 15 wird der SMD-Fertigungsprozess 27 im Falle der Bestückungsvariante beidseitig bestückte SMD-Baugruppen 59 zur Bestückung der ersten SMD-Bearbeitungsseite 43 und zur nachfolgenden Bestückung der zweiten SMD-Bearbeitungsseite 44 zweimal durchlaufen. Zwischen den beiden SMD-Bearbeitungsseiten ergibt sich ein sonstiger Fertigungsprozessschritt 38, der den manuellen Prozessschritt 25 der Zwischenlagerung der teilmontierten Bildsensor-Baugruppen 39 beinhaltet. Im Falle der Bestückungsvariante einseitig bestückte SMD-Baugruppe 60 entfällt die Bearbeitung der zweiten SMD-Bearbeitungsseite 44 und somit auch der sonstige Fertigungsprozess 38 zur Zwischenlagerung der Bildsensor-Baugruppen 39. Der Bestückung der ersten SMD-Bearbeitungsseite 43 ist die Bauteil-Vorbereitung 52 vorangestellt. Hierbei handelt es sich um einen sonstigen Fertigungsprozess 38, welcher den manuellen Prozessschritt 25 der Modifikation des THD-Bildsensors 53 beinhaltet.

Durch die Verarbeitung des modifizierten Bildsensors im SMD-Fertigungsprozess 27 entstehen keine Änderungen am Fertigungsprozess selbst. Der SMD-Fertigungsprozess 27 setzt sich nach wie vor aus der Bepastung 28 der Bildsensor-Baugruppe mit Lotpaste, der Bestückung 29 mit SMD-Bauteilen und dem anschließenden Reflow-Löten 30 zusammen. Bei der Bepastung 28, der Bestückung 29 und dem Reflow-Löten 30 handelt es sich um automatisierte Fertigungsprozessschritte 24.

Da der modifizierte Bildsensor wie ein SMD-Bauteil behandelt wird, ist es nun möglich eine automatisierte Bestückung und Lötung zu realisieren. Bei der automatisierten Bestückung können Automaten mit optischen Messsystemen zum Einsatz kommen, welche den modifizierten Bildsensor anhand der modifizierten Bildsensor-Drahtanschlüsse zentrieren und genau bestücken können. Da die modifizierten Bildsensor-Drahtanschlüsse eine Referenz zur optisch sensitiven Fläche des Bildsensor-Dies 16 herstellen, kann somit bereits bei der Bestückung eine automatisierte Ausrichtung des modifizierten Bildsensor zur Bildsensor-Baugruppe erfolgen. Im folgenden Reflow-Löten wird dann der modifizierte Bildsensor mit der Bildsensor-Baugruppe verlötet.

Während der Verlötung führt der natürliche Prozess der Selbstzentrierung zur Sicherstellung bzw. weiteren Erhöhung der Ausrichtungsgenauigkeit des modifizierten Bildsensors bezüglich der Bildsensor-Baugruppe. Bei der Selbstzentrierung, der gemäß den Ausführungsbeispielen nun auch für den modifizierten THD-Bildsensor anwendbar wird, handelt es sich um einen Effekt, bei welchem sich die SMD-Bauteile selbst zum SMD-Anschlussmuster ausrichten. Ursache für diesen Effekt, welcher in "Grundlagen der Leiterplatten-Baugruppen-Entwicklung und Fertigung", Wolf-Dieter Schmidt, Kapitel 9.4.1.2, Seite 125-126 näher beschrieben wird, ist die Oberflächenspannung des flüssigen Lotes während des Reflow-Lötvorganges. Im Falle des modifizierten Bildsensors führt ein eventuell vorhandener Bestückungsversatz vor dem Löten zu einer Korrektur des Versatzes während des Lötvorgangs und somit zur Kompensation von Bestückungsungenauigkeiten.

Durch die Verarbeitung des modifizierten Bildsensors in einem SMD-Fertigungsprozess ergeben sich damit Vorteile dahingehend, dass der Gesamtplatzbedarf aufgrund der möglichen Verwendung eines SMD-Anschlussmusters verringert ist, da keine THD-Durchkontaktierungen und keine zusätzlichen Montage-Freihaltungen für Lötkolben bzw. Wellen löten notwendig sind und damit zusätzlicher Platz für die Montage weiterer Bauteile genutzt werden kann. Die dadurch verkleinerte Leiterplatte führt zu Herstellungsvorteilen und der THD-Fertigungsprozess für den THD-Bildsensor kann eingespart werden, so dass ein schlankerer Fertigungsablauf möglich ist. Auch die sonstigen Fertigungsprozessschritte (z.B. Zwischenlagerung der teilmontierten Bildsensor-Baugruppen) können reduziert und effizientere und automatisierte SMD-Fertigungsprozessschritte können eingeführt werden. Des Weiteren führt die Änderung des Prinzips der Ausrichtung des THD-Bildsensors zur Bildsensor-Baugruppe aufgrund des SMD-Fertigungsprozesses zu einer Erhöhung der Prozesssicherheit und Reproduzierbarkeit aufgrund erhöhter Genauigkeiten durch Nutzung optischer Messsysteme der Bestückungsautomaten sowie erhöhter Genauigkeiten durch Nutzung des Selbstzentrierungseffektes während des Reflow-Lötvorganges.

Wie bereits erwähnt, kann die Modifikation des THD-Bildsensors mittels Biegewerkzeug in drei Teilschritten Ausrichtung, Fixierung und Modifikation erfolgen.

Fig. 16 zeigt eine schematische Seitenansicht (oben) und Draufsicht (unten) einer mechanischen Ausrichtung eines THD-Bildsensors 89 in einem Biegewerkzeug gemäß einem ersten Ausführungsbeispiel mit mechanischer Ausrichtung. Ein Teil zur Ausrichtung des THD-Bildsensors 89 in Bezug auf das Biegewerkzeug besteht aus einem Oberteil 83 und einem Unterteil 82. Im ersten Schritt wird der THD-Bildsensor 89 in das Unterteil 82 eingelegt und mechanisch, z.B. mittels mechanischer Federn 88, an mechanische Anschläge 84 gedrückt. Diese mechanischen Anschläge 84 befinden sich direkt an den Bildsensor-Referenzpositionen in X-Richtung und Y-Richtung an und bilden damit einen direkten Bezug zur optisch aktiven Fläche des Bildsensor-Dies 16. Nach dem Einlegen wird dann das Oberteil 83 auf das Unterteil 82 gelegt und mechanisch, z.B. durch Klemmen oder Verschrauben, fixiert. Auch das Oberteil 83 weist mechanische Federn 88 auf und drückt so den THD-Bildsensor 89 von oben auf eine Referenzfläche 58, so dass nun eine mechanische Ausrichtung 79 in X-Richtung, eine mechanische Ausrichtung 80 in Y-Richtung und eine mechanische Ausrichtung 81 in Z-Richtung des THD-Bildsensors 89 in Bezug auf das Biegewerkzeug erreicht wird.

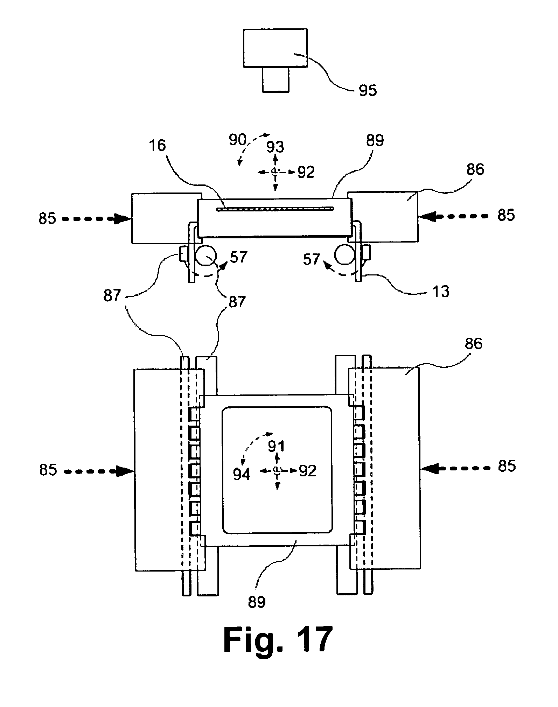

Fig. 17 zeigt eine schematische Seitenansicht (oben) und Draufsicht (unten) einer Fixierung und Modifikation des THD-Bildsensors 89 in einem Biegewerkzeug gemäß einem zweiten Ausführungsbeispiel mit optischer Ausrichtung. Im nächsten Schritt nach der Ausrichtung erfolgt die Fixierung des THD-Bildsensors 89 im Biegewerkzeug. Hierzu können zwei Klemmbacken 86 durch eine horizontale Verfahr-Bewegung 85 an den ausgerichteten THD-Bildsensor 89 geführt werden, die in der Endposition den THD-Bildsensor 89 in seiner ausgerichteten Position innerhalb des Biegewerkzeugs fixieren. Durch eine optische Ausrichtung des THD-Bildsensors 89 bezüglich des Biegewerkzeugs kann eine noch höhere Ausrichtegenauigkeit erreicht werden kann. Im Falle der optischen Ausrichtung gemäß Fig. 17 entfällt der in Fig. 16 gezeigte Teil der mechanischen Ausrichtung. Stattdessen ändert sich die Abfolge der Teilschritte zur Modifikation der Bildsensor-Drahtanschlüsse 13. Bei einer optischen Ausrichtung des THD-Sensors 89 zum Biegewerkzeug erfolgt gemäß Fig. 17 zuerst die Fixierung des THD-Bildsensors 89 im Biegewerkzeug mittels der Klemmbacken 86. Nach der Fixierung erfolgt die optische Ausrichtung. Hierfür kann ein optisches Messsystem 95 vorgesehen sein, welches die Lage der optisch aktiven Fläche des Bildsensor-Dies 16 innerhalb des Bildsensor-Gehäuses erfasst. Je nach Lager der optisch aktiven Fläche des Bildsensor-Dies 16 wird nach der Fixierung nun die Ausrichtung des THD-Bildsensors 89 zum Biegewerkzeug mit technisch geläufigen Mitteln, z.B. mit einer motorgetriebenen linearen Verschiebeeinheit, vorgenommen. Hierbei wird eine Lage-Korrektur des THD-Bildsensors 89 in X-Richtung 91, Y-Richtung 92 und Z-Richtung 93 vorgenommen. Es kann dabei vorgesehen werden, dass im Sinne einer Regelschleife die Ausrichtung dergestalt verändert wird, dass am

Ende ein Istwert einem Sollwert entspricht. Darüber hinaus können auch eine Korrektur des Bildsensor-Tilt 90 und einer Rotation 94 durchgeführt werden, indem mit technisch geläufigen Mitteln die Neigung und die Drehung dergestalt verändert werden, dass eine Übereinstimmung des Istwertes mit einem Sollwert erzielt wird.

Nach der Ausrichtung und Fixierung im mechanischen bzw. der Fixierung und Ausrichtung im optischen Fall liegt nun ein fixierter THD-Bildsensor 89 vor, welcher sich innerhalb des Biegewerkzeugs in einer definierten Position befindet. Je nach Anwendungsfall können nun, z.B. Variationen an der Position des THD-Bildsensors 89 im Biegewerkzeug in X-Richtung 91, Y-Richtung 92, Z-Richtung 93, Bildsensor-Tilt 90 und Rotation 94 vorgenommen werden. Nachdem die endgültige Position des THD-Bildsensors 89 im Biegewerkzeug eingestellt wurde, erfolgt die Modifikation der originalen Bildsensor-Drahtanschlüsse 13. Hierzu wird der fixierte und ausgerichtete THD-Bildsensor 89 mit seinen Bildsensor-Drahtanschlüssen 13 einer Biegemechanik 87 zugeführt. Die Biegemechanik 87 führt im Falle des Fig. 17 eine kreisförmige Biegebewegung 57 aus, die zur modifizierten Bildsensor-Drahtanschlussform führt.

Es gibt andere Möglichkeiten, eine Biegebewegung auszuführen, die zu alternativen Biegeformen führen, z.B. zur sogenannten Gull-Wing-Form gemäß IPC J-STD-001 D DE, "Anforderungen an gelötete elektrische und elektronische Baugruppen", Februar 2005, Kapitel 7.6.7, Seite 25.

Nach Abschluss der Modifikation der Bildsensor-Drahtanschlüsse 13 wird der modifizierte THD-Bildsensor 89 aus dem Biegewerkzeug entnommen und kann nachfolgend im SMD-Fertigungsprozess verarbeitet werden.

Digitale Kameras benötigen zur bestimmungsgemäßen Funktion eine Ausrichtung der optisch sensitiven Fläche des Bildsensor-Dies, da sonst auf nachteilige Weise nicht das gesamte Bild scharf abgebildet werden kann. Bisher war es nicht möglich, THD-Bildsensoren im SMD-Verarbeitungsprozess zu verarbeiten, da im Falle eines SMD-Verarbeitungsprozesses die notwendige Ausrichtung des THD-Bildsensors nicht vorliegt. Durch die vorstehend beschriebenen Ausführungsbeispiele wird es nun möglich, THD-Bildsensoren mit mindestens drei erfindungsgemäß modifizierten Bildsensor-Drahtanschlüssen im SMD-Verarbeitungsprozess zu verarbeiten, so dass die Bildsensor-Drahtanschlüsse nicht durch die Leiterplatte durchgesteckt und verlötet werden müssen und als Ergebnis des Verarbeitungsprozesses eine Ausrichtung der optisch aktiven Fläche des Bildsensor-Dies in der Kamera erreicht und das gesamte Bild scharf auf der optisch aktiven Fläche des Bildsensor-Dies abgebildet werden kann.

Zusammenfassend wurde eine Bildsensor-Baugruppe für eine Kamera, vorzugsweise eine digitale Industriekamera, mit einer Leiterplatte und einem oder mehreren elektronischen Bauteilen, ein Verfahren zu deren Herstellung und ein Biegewerkzeug beschrieben, wobei zumindest eines der Bauteile ein modifizierter THD-Bildsensor ist, der mittels eines angepassten Biegewerkzeugs modifizierte Bildsensor-Drahtanschlüsse aufweist, die durch ein Fertigungsverfahren auf der Oberfläche der Leiterplatte montiert werden, so dass die Drahtanschlüsse nicht durch die Leiterplatte durchgesteckt und verlötet werden müssen, und dass sie eine Referenz zu einer optisch sensitiven Fläche des Bildsensors bilden. Der modifizierte THD-Bildsensor kann somit in einem SMD-Fertigungsprozess bestückt werden.

Die vorgestellten Lösungsalternativen gemäß den Ausführungsbeispielen können im Zusammenhang mit verschiedensten Bildaufnahmegeräten und Kameras eingesetzt werden, bei denen eine Baugruppe mit THD-Bildsensor eingesetzt wird. Die Modifikation der Drahtanschlüsse ist nicht auf die vorstehend beschriebenen Ausführungsbeispiele beschränkt. Verschiedenste Biege- oder andere Modifikationsformen sowie alternative Biegeverfahren der Drahtanschlüsse können zur Ermöglichung einer Oberflächenmontage des THD-Bildsensors im Rahmen der vorliegenden Erfindung vorgesehen sein.

## Patentansprüche

1. Bildsensor-Baugruppe für eine Kamera, mit:
a. einer Leiterplatte (5); und
b. einem auf der Oberfläche der Leiterplatte (5) montierten Bildsensor (54), der als bedrahtetes THD-Bauteil mit Drahtanschlüssen (18) ausgestaltet ist,
c. wobei die Drahtanschlüsse (18) des Bildsensors (54) durch einen Biegevorgang so modifiziert sind, dass eine Montage mit Oberflächenbestückungs-Technologie ermöglicht ist und dass sie eine Referenz zur optisch sensitiven Fläche des Bildsensors (54) bilden.

2. Bildsensor-Baugruppe nach Anspruch 1, wobei die modifizierten Drahtanschlüsse (18) des Bildsensors (54) J-förmig ausgebildet sind.

3. Bildsensor-Baugruppe nach Anspruch 1, wobei die modifizierten Drahtanschlüsse (18) des Bildsensors (54) eine Gull-Wing-Form aufweisen.

4. Bildsensor-Baugruppe nach einem der vorgenannten Ansprüche, wobei die modifizierten Drahtanschlüsse (18) des Bildsensors (54) unterschiedliche Längen aufweisen, so dass eine vorbestimmte Neigung des Bildsensors (54) gegenüber einer Objektebene (77) der Kamera erreicht ist.

5. Bildsensor-Baugruppe nach einem der vorgenannten Ansprüche, wobei die Länge der modifizierten Drahtanschlüsse (18) des Bildsensors (54) in Abhängigkeit eines optischen Filters (72) im Strahlengang der Kamera gewählt ist.

6. Bildsensor-Baugruppe nach einem der vorgenannten Ansprüche, wobei die Leiterplatte (5) auf der Oberfläche ein Anschlussmuster (55) aufweist, das für jeden modifizierten Drahtanschluss des Bildsensors (54) eine elektrisch leitende Kontaktfläche zur Oberflächenmontage aufweist (56).

7. Digitale Industriekamera mit einer Bildsensor-Baugruppe nach einem der Ansprüche 1 bis 6, die an einem Kameragehäuseträger (1) fixiert ist.

8. Verfahren zur Herstellung einer Bildsensor-Baugruppe, mit den Schritten:
a. Modifizieren der ursprünglichen Drahtanschlüsse (13) eines als bedrahtetes THD-Bauteil ausgestalteten Bildsensors (21) durch einen Biegevorgang in solcher Weise, dass eine Oberflächenmontage des modifizierten Bildsensors (54) ermöglicht ist und dass die modifizierten Drahtanschlüsse (18) eine Referenz zur optisch sensitiven Fläche des modifizierten Bildsensors (54) bilden; und
b. Bestücken einer Leitplatte (5) der Bildsensor-Gruppe mit dem modifizierten Bildsensor (54) unter Verwendung eines Oberflächenbestückungsprozesses.

9. Verfahren nach Anspruch 8, mit Ausrichten und Fixieren des Bildsensors (21) und Durchführen des Biegevorgangs in Abhängigkeit der Lage der optisch sensitiven Fläche des Bildsensors (21).

10. Verfahren nach Anspruch 8, wobei die Ausrichtung unter Verwendung zumindest eines mechanischen Anschlags zur Festlegung zumindest einer Referenz-position erfolgt, und wobei das Fixieren durch mechanisches Klemmen des Bildsensorgehäuses gegen ein Biegewerkzeug erfolgt; oder
wobei die Ausrichtung basierend auf einer optischen Vermessung der optisch sensitiven Fläche des Bildsensors (21) erfolgt.

11. Verfahren nach einem der Ansprüche 8 bis 10, wobei die Modifizierung der ursprünglichen Drahtanschlüsse (13) auch zur Korrektur von Toleranzwerten in zumindest einer Raumrichtung herangezogen wird.

12. Biegewerkzeug zur Modifikation von Drahtanschlüssen (13) eines als THD-Bauteil ausgestalteten Bildsensors (21), mit:
a. Ausrichtungsmitteln (82, 83, 84, 88; 95) zum Ausrichten des Bildsensors (89);
b. Fixierungsmitteln (86) zur Fixierung des Bildsensors (89) in seiner ausgerichteten Position; und
c. Biegemitteln (87) zur Durchführung einer vorbestimmten Biegebewegung, die zu einer gewünschten Biegeform der modifizierten Drahtanschlüsse (18) führt.

13. Biegewerkzeug nach Anspruch 12, wobei die Ausrichtungsmittel (82, 83, 84, 88; 95) zumindest einen mit einer Referenzposition für die optisch sensitive Fläche des Bildsensors (21) verknüpften mechanischen Anschlag (84) aufweisen.

14. Biegewerkzeug nach Anspruch 12, wobei die Ausrichtungsmittel ein optisches Messsystem (95) aufweisen, welches die Lage der optisch sensitiven Fläche des Bildsensors (21) innerhalb des Bildsensorgehäuses erfasst.

15. Biegewerkzeug nach einem der Ansprüche 12 bis 14, wobei die Fixierungsmittel zumindest zwei Klemmbacken (86) aufweisen.

## Geänderte Patentansprüche

### Geänderte Patentansprüche gemäss Regel 137(2) EPÜ.

**1.** Bildsensor-Baugruppe für eine Kamera, mit:
a. einer Leiterplatte (5); und
b. einem auf der Oberfläche der Leiterplatte (5) mittels Oberflächenbestückungs-Technologie montierten Bildsensor (54), der als bedrahtetes THD-Bauteil mit Drahtanschlüssen (18) ausgestaltet ist,
c. wobei die Drahtanschlüsse (18) des Bildsensors (54) durch einen Biegevorgang so modifiziert sind, dass eine Montage mit der Oberflächenbestückungs-Technologie ermöglicht ist und dass sie eine Referenz zur optisch sensitiven Fläche des Bildsensors (54) bilden.

**2.** Bildsensor-Baugruppe nach Anspruch 1, wobei die modifizierten Drahtanschlüsse (18) des Bildsensors (54) J-förmig ausgebildet sind.

**3.** Bildsensor-Baugruppe nach Anspruch 1, wobei die modifizierten Drahtanschlüsse (18) des Bildsensors (54) eine Gull-Wing-Form aufweisen.

**4.** Bildsensor-Baugruppe nach einem der vorgenannten Ansprüche, wobei die modifizierten Drahtanschlüsse (18) des Bildsensors (54) unterschiedliche Längen aufweisen, so dass eine vorbestimmte Neigung des Bildsensors (54) gegenüber einer Objektebene (77) der Kamera erreicht ist.

**5.** Bildsensor-Baugruppe nach einem der vorgenannten Ansprüche, wobei die Länge der modifizierten Drahtanschlüsse (18) des Bildsensors (54) in Abhängigkeit eines optischen Filters (72) im Strahlengang der Kamera gewählt ist.

**6.** Bildsensor-Baugruppe nach einem der vorgenannten Ansprüche, wobei die Leiterplatte (5) auf der Oberfläche ein Anschlussmuster (55) aufweist, das für jeden modifizierten Drahtanschluss des Bildsensors (54) eine elektrisch leitende Kontaktfläche zur Oberflächenmontage aufweist (56).

**7.** Digitale Industriekamera mit einer Bildsensor-Baugruppe nach einem der Ansprüche 1 bis 6, die an einem Kameragehäuseträger (1) fixiert ist.

**8.** Verfahren zur Herstellung einer Bildsensor-Baugruppe, mit den Schritten:
a. Modifizieren der ursprünglichen Drahtanschlüsse (13) eines als bedrahtetes THD-Bauteil ausgestalteten Bildsensors (21) durch einen Biegevorgang in solcher Weise, dass eine Oberflächenmontage des modifizierten Bildsensors (54) ermöglicht ist und dass die modifizierten Drahtanschlüsse (18) eine Referenz zur optisch sensitiven Fläche des modifizierten Bildsensors (54) bilden; und
b. Bestücken einer Leitplatte (5) der Bildsensor-Gruppe mit dem modifizierten Bildsensor (54) unter Verwendung eines Oberflächenbestückungsprozesses.

**9.** Verfahren nach Anspruch 8, mit Ausrichten und Fixieren des Bildsensors (21) und Durchführen des Biegevorgangs in Abhängigkeit der Lage der optisch sensitiven Fläche des Bildsensors (21).

**10.** Verfahren nach Anspruch 8, wobei die Ausrichtung unter Verwendung zumindest eines mechanischen Anschlags zur Festlegung zumindest einer Referenzposition erfolgt, und wobei das Fixieren durch mechanisches Klemmen des Bildsensorgehäuses gegen ein Biegewerkzeug erfolgt; oder
wobei die Ausrichtung basierend auf einer optischen Vermessung der optisch sensitiven Fläche des Bildsensors (21) erfolgt.

**11.** Verfahren nach einem der Ansprüche 8 bis 10, wobei die Modifizierung der ursprünglichen Drahtanschlüsse (13) auch zur Korrektur von Toleranzwerten in zumindest einer Raumrichtung herangezogen wird.

**12.** Biegewerkzeug zur Modifikation von Drahtanschlüssen (13) eines als THD-Bauteil ausgestalteten Bildsensors (21), mit:
a. Ausrichtungsmitteln (82, 83, 84, 88; 95) zum Ausrichten des Bildsensors (89) in Bezug zu einer optisch aktiven Fläche des Bildsensors (89);
b. Fixierungsmitteln (86) zur Fixierung des Bildsensors (89) in seiner ausgerichteten Position; und
c. Biegemitteln (87) zur Durchführung einer vorbestimmten Biegebewegung, die zu einer gewünschten Biegeform der modifizierten Drahtanschlüsse (18) führt.

**13.** Biegewerkzeug nach Anspruch 12, wobei die Ausrichtungsmittel (82, 83, 84, 88; 95) zumindest einen mit einer Referenzposition für die optisch sensitive Fläche des Bildsensors (21) verknüpften mechanischen Anschlag (84) aufweisen.

**14.** Biegewerkzeug nach Anspruch 12, wobei die Ausrichtungsmittel ein optisches Messsystem (95) aufweisen, welches die Lage der optisch sensitiven Fläche des Bildsensors (21) innerhalb des Bildsensorgehäuses erfasst.

**15.** Biegewerkzeug nach einem der Ansprüche 12 bis 14, wobei die Fixierungsmittel zumindest zwei Klemmbacken (86) aufweisen.
